# EUROPEAN PATENT SPECIFICATION

(11) **EP 2 355 198 B1**
(45) Date of publication and mention of the grant of the patent: **09.09.2015**
(21) Application number: 11003715.7
(22) Date of filing: 08.05.2006
(51) Int. Cl.: H01L 51/50, H01L 51/54

(54) **OLED electron-injecting layer**
Elektroneninjektionsschicht für OLED
Couche d'injection d'électrons pour OLED

(43) Date of publication of application: 10.08.2011
(62) Divisional of application: 06759222.0
(73) Proprietor: Global OLED Technology LLC, Wilmington, Delaware 19801 (US)
(72) Inventor: Liao, Liang-Sheng, Rochester, New York, 14620 (US); Slusarek, Wojciech Kazimierz, Rochester, New York, 14625 (US); Ricks, Michele Lee, Rochester, New York 14626 (US); Young, Ralph Howard, Rochester, New York 14620 (US); Comfort, Dustin Lewis, Hamlin, N.Y. 14464 (US)
(74) Representative: Ter Meer Steinmeister & Partner

(56) References cited:
- EP-A2- 1 099 744
- US-A1- 2005 104 511

## Description

### FIELD OF INVENTION

The present invention relates to an organic light-emitting device (OLED) in which an organic material having a strong oxidizing property is used in an electron-injecting layer of the device.

### BACKGROUND OF THE INVENTION

OLEDs, as described by Tang in commonly assigned U.S. Patent 4,356,429, are commercially attractive because they offer the promise of low cost fabrication of high density pixel displays exhibiting bright electroluminance (EL) with long lifetime, high luminous efficiency, low drive voltage, and wide color range.

A typical OLED includes two electrodes and one organic EL unit disposed between the two electrodes. The organic EL unit commonly includes an organic hole-transporting layer (HTL), organic light-emitting layer (LEL), and an organic electron-transporting layer (ETL). One of the electrodes is the anode, which is capable of injecting positive charges (holes) into the HTL of the EL unit, and the other electrode is the cathode, which is capable of injecting negative charges (electrons) into the ETL of the EL unit. When the anode is biased with a certain positive electrical potential relative to the cathode, holes injected from the anode and electrons injected from the cathode can recombine and emit light from the LEL. At least one of the electrodes is optically transmissive, and the emitted light can be seen through the transmissive electrode.

Significant efforts have been made in selecting suitable materials and forming different layer structures in OLEDs to achieve improved EL performance. Numerous OLEDs with alternative layer structures have been disclosed. For example, in addition to the three layer OLEDs that contain a LEL between the HTL and the ETL (denoted as HTL/LEL/ETL), there are other multilayer OLEDs that contain additional functional layers in the EL unit, such as a hole-injecting layer (HIL), an electron-injecting layer (EIL), an electron-blocking layer (EBL), or a hole-blocking layer (HBL), or the combination thereof. These new layer structures with new materials have indeed resulted in improved device performance.

As is known, electron transport in OLED is generally less efficient than hole transport. As a result, the electron-hole recombination in LEL is sometimes unbalanced with insufficient electrons. In order to achieve more efficient electron-hole recombination, much attention has been paid in forming an effective ETL or EIL using suitable electron-transporting material (ETM) in OLEDs. For example, the commonly used ETL or EIL in OLEDs includes the ETM of tris(8-hydroxyquinoline)aluminum (Alq), 4,7-diphenyl-1,10-phenanthroline (Bphen), 2,9-dimethyl-4,7-diphenyl-1,10-phenanthroline (BCP), and 2,2'-[1,1'-biphenyl]-4,4'-diylbis[4,6-(p-tolyl)-1,3,5-triazine] (TRAZ).

According to prior art, the selection of practically useful organic ETMs in OLEDs is limited to those having a reduction potential less than -1.0 V vs. a Saturated Calomel Electrode (SCE) or having a LUMO less than 3.3 eV below the vacuum energy level (E_{vac}). This is because the LEL in an OLED typically has a reduction potential less than -1.0 V vs. SCE. Therefore if any organic material having a reduction potential greater than -1.0 V vs. SCE were used as an ETL in the OLED, it would produce an electron injection barrier between the ETL and the LEL. Especially, if any organic material having a reduction potential greater than -0.5 V vs. SCE were used as an ETL in the OLED, it would produce an electron injection barrier greater than 0.5 eV. Electron injection from the ETL into the LEL would be very difficult or impossible, resulting in little or no EL emission from the OLED. However, the commonly used ETMs, although forming a low or no barrier for electron injection at LEL/ETL interface, exhibit a relatively high barrier for electron injection at the interface between the ETL and the cathode, especially when the cathode material has a work function higher than 4.0 eV. This high barrier interface between the ETL and the cathode can be modified by inserting a thin insulating layer or by doping the ETL with a material having a work function lower than 3.0 eV, but this interface will be degraded eventually during operation.

OLEDs with electron transporting layers comprising Alq or Bphen are disclosed in US 2005/0104511 A1.

Therefore, it would be advantageous to find a way to broaden the material selection for ETL (EEL), to use the material having a reduction potential greater than that of commonly used ETMs, and to produce a stable interface between organic layer and the cathode in OLEDs.

### SUMMARY OF THE INVENTION

It is therefore an object of the present invention to improve the EL performance of the OLED.

The object is achieved by an organic light-emitting device (OLED) according to claim 1.

The present invention makes use of a second electron-injecting layer including an organic material having a reduction potential greater than -1.0 eV in direct contact with the cathode and forming a stable interface between the cathode and this layer with no electron injection barrier from the cathode into the electron-injecting layer. It is an advantage of the present invention that the OLED with the second electron-injecting layer can not only increase the lifetime but also reduce the voltage rise during operation, which is useful for making high quality active matrix OLED display and other electronic devices. It is another advantage of the present invention that a stable metal, such as Ag, Au, Al, and Cu, can be used to form the cathode. These stable metals do not readily react with water or oxygen to form dark spots in the OLEDs.

### BRIEF DESCRIPTION OF THE DRAWINGS

FIG. 1 shows a cross-sectional view of a prior art OLED;
FIG. 2 shows a cross-sectional view of one embodiment of an OLED prepared in accordance with the present invention;
FIG. 3 shows a cross-sectional view of another embodiment of an OLED prepared in accordance with the present invention;
FIG. 4 shows a cross-sectional view of yet another embodiment of an OLED prepared in accordance with the present invention;
FIG. 5 shows a cross-sectional view of yet another embodiment of an OLED prepared in accordance with the present invention;
FIG. 6 is a graph showing the normalized luminance vs. operational time of a group of OLEDs tested at room temperature and at 80 mA/cm²;
FIG. 7 is a graph showing the drive voltage vs. operational time of the group of OLEDs tested at room temperature and at 80 mA/cm²;
FIG. 8 is a graph showing the normalized luminance vs. operational time of another group of OLEDs tested at room temperature and at 80 mA/cm²; and
FIG. 9 is a graph showing the drive voltage vs. operational time of the other group of OLEDs tested at room temperature and at 80 mA/cm².

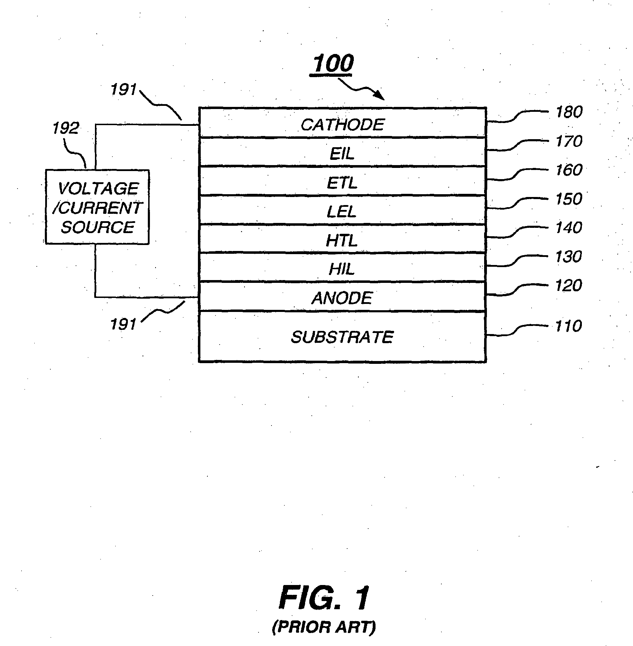

It will be understood that FIGS. 1-5 are not to scale since the thickness differences of various layers are too great to permit depiction to scale.

### DETAILED DESCRIPTION OF THE INVENTION

There is shown a cross-sectional view of a prior art OLED in FIG. 1. OLED **100** includes substrate **110**, anode **120**, HIL **130**, HTL **140**, LEL **150**, ETL **160**, EIL **170**, and cathode **180** (HIL **130**, HTL **140**, LEL **150**, ETL **160**, and EIL **170** form an organic EL unit in between the anode **120** and cathode **180**). OLED **100** is externally connected to a voltage/current source **192** through electrical conductors **191**. OLED **100** is operated by applying an electric potential produced by the voltage/current source **192** between the pair of contact electrodes, anode **120**, and cathode **180**.

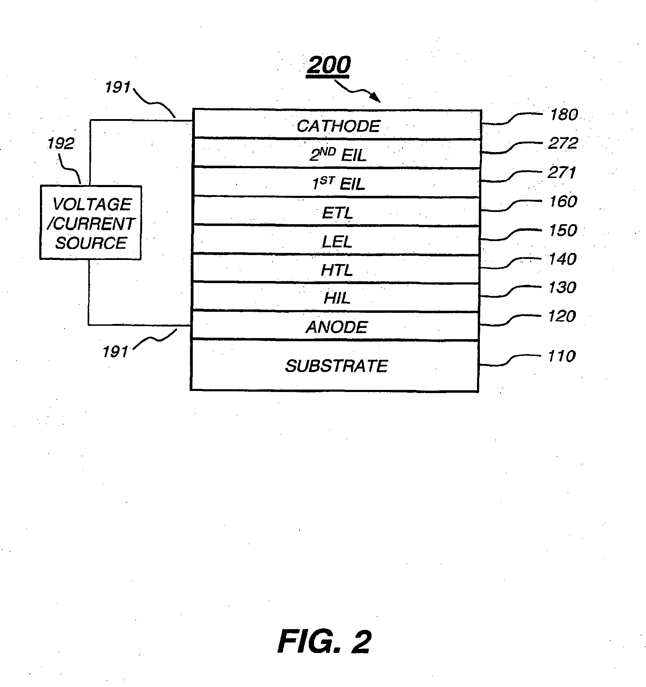

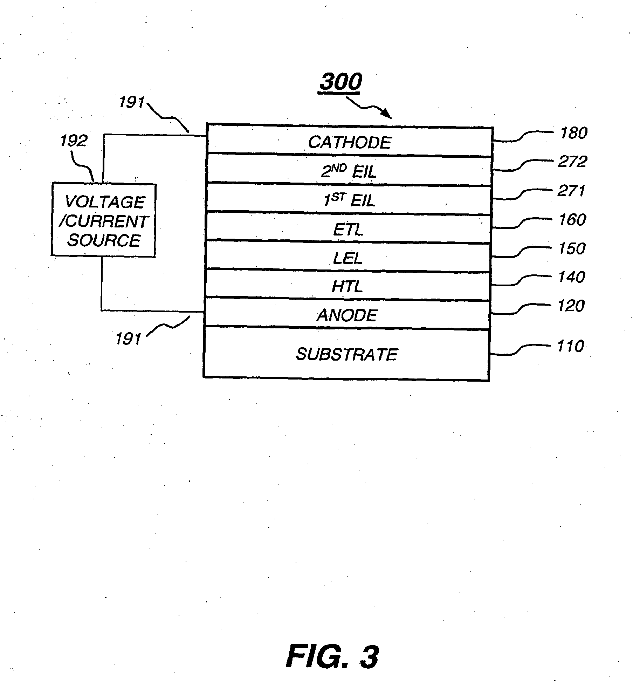

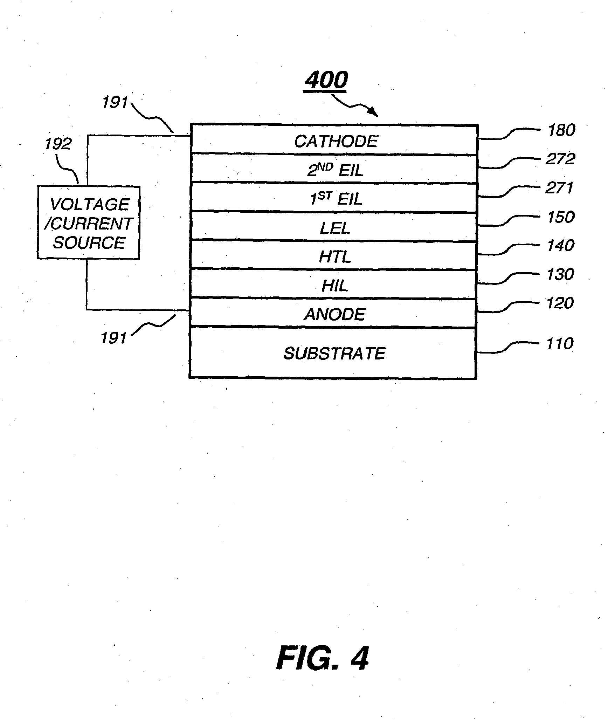

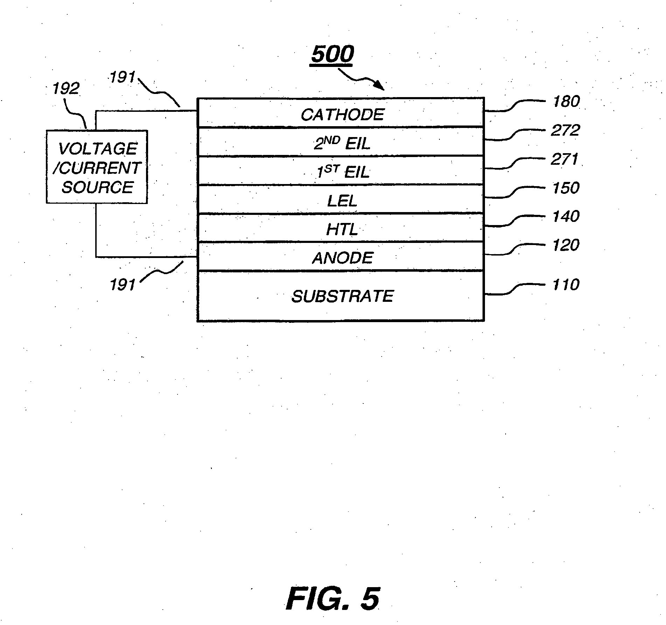

There is shown a cross-sectional view of one embodiment of an OLED in accordance with the present invention in FIG. 2. OLED **200** includes substrate **110,** anode **120**, HIL **130,** HTL **140,** LEL **150,** ETL **160,** the 1^{st} EIL **271**, the 2^{nd} EIL **272**, and cathode **180**. OLED **200** is the same as OLED 100 except that OLED **200** has two EILs (EIL **271** and EIL **272**). OLED **200** is also externally connected to a voltage/current source **192** through electrical conductors **191**. Shown in FIGS. 3, 4, and 5 are OLED **300**, OLED **400**, and OLED **500**, respectively, which are some other embodiments of OLEDs prepared in accordance with the present invention. OLED **300** in FIG. 3 is the same as OLED 200 except that there is no HIL **130** in OLED **300**; OLED **400** in FIG. 4 is the same as OLED **200** except that there is no ETL **160** in OLED **400**; and OLED **500** in FIG. 5 is the same as OLED **200** except that there is no HIL **130** nor ETL **160** in OLED **500**. Note that the substrate can alternatively be located adjacent to the cathode, or the substrate can actually constitute the anode or cathode. The total combined thickness of the organic layers is preferably less than 500 nm.

The present invention can be employed in the making of most OLED device configurations. These include very simple structures including a single anode and cathode to more complex devices, such as passive matrix displays including orthogonal arrays of anodes and cathodes to form pixels, and active matrix displays where each pixel is controlled independently, for example, with thin film transistors (TFTs). Such TFTs can be constructed using amorphous silicon, low temperature polycrystalline silicon, single crystal silicon, other inorganic semiconductors, or organic semiconductor materials.

The following will be the description of the device structure, material selection, and fabrication process of the OLEDs in accordance with the present invention.

Substrate **110** can be an organic solid, an inorganic solid, or includes organic and inorganic solids that provides a supporting backplane to hold the OLED. Substrate **110** can be rigid or flexible and can be processed as separate individual pieces, such as sheets or wafers, or as a continuous roll. Typical substrate materials include glass, plastic, metal, ceramic, semiconductor, metal oxide, semiconductor oxide, or semiconductor nitride, or combinations thereof. Substrate **110** can be a homogeneous mixture of materials, a composite of materials, or multiple layers of materials. Substrate **110** can also be a backplane containing thin-film transistor (TFT) circuitry commonly used for preparing OLED display, e.g. an active matrix low temperature polysilicon TFT substrate. The substrate **110** can either be light transmissive or opaque, depending on the intended direction of light emission. The light transmissive property is desirable for viewing the EL emission through the substrate. Transparent glass or plastic is commonly employed in such cases. For applications where the EL emission is viewed through the top electrode, the transmissive characteristic of the bottom support is immaterial, and therefore can be light transmissive, light absorbing, or light reflective. Substrates for use in this case include, but are not limited to, glass, plastic, semiconductor materials, ceramics, and circuit board materials, or any others commonly used in the formation of OLEDs, which can be either passive matrix devices or active matrix devices.

Anode **120** is formed over substrate **110**. When EL emission is viewed through the substrate **110**, the anode should be transparent or substantially transparent to the emission of interest. For applications where EL emission is viewed through the top electrode, the transmissive characteristics of the anode material are immaterial and any conducting or semiconducting material can be used, regardless if it is transparent, opaque, or reflective. Desired anode materials can be deposited by any suitable way such as thermal evaporation, sputtering, chemical vapor deposition, or electrochemical means. Anode materials can be patterned using well known photolithographic processes.

The material for use to form anode **120** can be selected from inorganic materials, or organic materials, or combination thereof. The anode **120** can contain the element material selected from aluminum, silver, gold, copper, zinc, indium, tin, titanium, zirconium, hafnium, niobium, tantalum, molybdenum, tungsten, manganese, iron, ruthenium, rhodium, iridium, nickel, palladium, platinum, silicon, or germanium, or combinations thereof. The anode **120** can also contain a compound material, such as a conducting or semiconducting compound. The conducting or semiconducting compound can be selected from the oxides of titanium, zirconium, hafnium, niobium, tantalum, molybdenum, tungsten, manganese, iron, ruthenium, rhodium, iridium, nickel, palladium, platinum, copper, zinc, indium, tin, silicon, or germanium, or combinations thereof. The conducting or semiconducting compound can be selected from the sulfides of titanium, zirconium, hafnium, niobium, tantalum, molybdenum, tungsten, manganese, iron, ruthenium, rhodium, iridium, nickel, palladium, platinum, copper, zinc, indium, tin, silicon, or germanium, or combinations thereof. The conducting or semiconducting compound can be selected from the selenides of titanium, zirconium, hafnium, niobium, tantalum, molybdenum, tungsten, manganese, iron, ruthenium, rhodium, iridium, nickel, palladium, platinum, copper, zinc, indium, tin, silicon, or germanium, or combinations thereof. The conducting or semiconducting compound can be selected from the tellurides of titanium, zirconium, hafnium, niobium, tantalum, molybdenum, tungsten, manganese, iron, ruthenium, rhodium, iridium, nickel, palladium, platinum, copper, zinc, indium, tin, silicon, or germanium, or combinations thereof. The conducting or semiconducting compound can be selected from the nitrides of titanium, zirconium, hafnium, niobium, tantalum, molybdenum, tungsten, manganese, iron, ruthenium, rhodium, iridium, nickel, palladium, platinum, copper, zinc, indium, tin, silicon, or germanium, or combinations thereof. Preferably, the conducting or semiconducting compound can be selected from indium tin oxide, tin oxide, aluminum-doped zinc oxide, indium-doped zinc oxide, magnesium indium oxide, nickel tungsten oxide, zinc sulfide, zinc selenide, or gallium nitride, or the combination thereof.

It is often useful to provide a hole-injecting layer 130 between anode **120** and hole-transporting layer **140**. The hole-injecting material can serve to improve the film formation property of subsequent organic layers and to facilitate injection of holes into the hole-transporting layer. Suitable materials for use in the hole-injecting layer include, but are not limited to, porphyrinic compounds as described in U.S. Patent 4,720,432, plasma-deposited fluorocarbon polymers as described in U.S. Patents 6,127,004, 6,208,075 and 6,208,077, some aromatic amines, for example, m-MTDATA (4,4',4"-tris[(3-methylphenyl)phenyl-amino]triphenylamine), and inorganic oxides including vanadium oxide (VOx), molybdenum oxide (MoOx), and nickel oxide (NiOx). Alternative hole-injecting materials reportedly useful in organic EL devices are described in EP 0 891 121 A1 and EP 1 029 909 A1. Hexaazatriphenylene derivatives are also useful HIL materials, as described in U.S. Patent 6,720,573.

Another class of suitable materials for use in the HIL includes p-type doped organic materials. A p-type doped organic material typically includes a hole-transporting material such as an aromatic amine (see below) that is doped with an electron accepting dopant. Such dopants can include, for example, 2,3,5,6-tetrafluoro-7,7,8,8-tetracyanoquinodimethane (F4-TCNQ) and other derivatives of 7,7,8,8-tetracyanoquinodimethane (TCNQ), and inorganic oxidizing agents such as iodine, FeC13, FeF3, SbC15, some other metal chlorides, and some other metal fluorides. The p-type doped concentration is preferably in the range of 0.01-20 vol. %. Such layers materials are further described in, for example, U.S. Patents 5,093,698, 6,423,429, and 6,597,012.

The thickness of the HIL can be in the range of from 0.1 nm to 200 nm, preferably, in the range of from 0.5 nm to 150 nm.

The HTL **140** contains at least one hole-transporting material such as an aromatic tertiary amine, where the aromatic tertiary amine is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. in U.S. Patent 3,180,730. Other suitable triarylamines substituted with one or more vinyl radicals or at least one active hydrogen-containing group are disclosed by Brantley, et al. in U.S. Patents 3,567,450 and 3,658,520.

A more preferred class of aromatic tertiary amines includes compounds that include at least two aromatic tertiary amine moieties as described by Van Slyke and Tang et al. in U.S. Patents 4,720,432 and 5,061,569. The HTL can be formed of a single or a mixture of aromatic tertiary amine compounds. Illustrative of useful aromatic tertiary amines are the following:
1,1-Bis(4-di-p-tolylaminophenyl)cyclohexane;
1,1-Bis(4-di-p-tolylaminophenyl)-4-phenylcyclohexane;
N,N,N',N'-tetraphenyl-4,4"'-diamino-1,1':4',1":4",1"'-quaterphenyl;
Bis(4-dimethylamino-2-methylphenyl)phenylinethane;
1,4-bis[2-[4-[N,N-di(p-toly)amino]phenyl]vinyl]benzene (BDTAPVB);
N,N,N',N'-Tetra-p-tolyl-4,4'-diaminobiphenyl;
N,N,N',N'-Tetraphenyl-4,4'-diaminobiphenyl;
N,N,N',N'-tetra-1-naphthyl-4,4'-diaminobiphenyl;
N,N,N',N'-tetra-2-naphthyl-4,4'-diaminobiphenyl;
N-Phenylcarbazole;
4,4'-Bis[N-(1-naphthyl)-N-phenylamino]biphenyl (NPB);
4,4'-Bis[N-(1-naphthyl)-N-(2-naphthyl)amino]biphenyl (TNB);
4,4'-Bis[N-(1-naphthyl)-N-phenylamino]p-terphenyl;
4,4'-Bis[N-(2-naphthyl)-N-phenylamino]biphenyl;
4,4'-Bis[N-(3-acenaphthenyl)-N-phenylamino]biphenyl;
1,5-Bis[N-(1-naphthyl)-N-phenylamino]naphthalene;
4,4'-Bis[N-(9-anthryl)-N-phenylamino]biphenyl;
4,4'-Bis[N-(1-anthryl)-N-phenylamino]-p-terphenyl;
4,4'-Bis [N-(2-phenanthryl)-N-phenylamino]biphenyl;
4,4'-Bis[N-(8-fluoranthenyl)-N-phenylamino]biphenyl;
4,4'-Bis[N-(2-pyrenyl)-N-phenylamino]biphenyl;
4,4'-Bis[N-(2-naphthacenyl)-N-phenylamino]biphenyl;
4,4'-Bis[N-(2-perylenyl)-N-phenylamino]biphenyl;
4,4'-Bis[N-(1-coronenyl)-N-phenylamino]biphenyl;
2,6-Bis(di-p-tolylamino)naphthalene;
2,6-Bis[di-(1-naphthyl)amino]naphthalene;
2,6-Bis[N-(1-naphthyl)-N-(2-naphthyl)amino]naphthalene;
N,N,N',N'-Tetra(2-naphthyl)-4,4"-diamino-p-terphenyl;
4,4'-Bis{N-phenyl-N-[4-(1-naphthyl)-phenyl]amino}biphenyl;
2,6-Bis[N,N-di(2-naphthyl)amino]fluorene;
4,4',4"-tris[(3-methylphenyl)phenylamino]triphenylamine (MTDATA); and
4,4'-Bis[N-(3-methylphenyl)-N-phenylamino]biphenyl (TPD).

Another class of useful hole-transporting materials includes polycyclic aromatic compounds as described in EP 1 009 041. Some hole-injecting materials described in EP 0 891 121 A1 and EP 1 029 909 A1 can also make useful hole-transporting materials. In addition, polymeric hole-transporting materials can be used including poly(N-vinylcarbazole) (PVK), polythiophenes, polypyrrole, polyaniline, and copolymers including poly(3,4-ethylenedioxy-thiophene)/poly(4-styrenesulfonate) also called PEDOT/PSS.

The thickness of the HTL can be in the range of from 5 nm to 200 nm, preferably, in the range of from 10 nm to 150 nm.

The LEL **150** can include a luminescent fluorescent or phosphorescent material where electroluminescence is produced as a result of electron-hole pair recombination in this layer. The light-emitting layer can include a single material, but more commonly contains at least one host material doped with at least one guest emitting material or materials where light emission comes primarily from the emitting materials and can be of any color. This guest emitting material is often referred to as a luminescent dopant material. The host materials in the light-emitting layer can be an electron-transporting material as defined below, a hole-transporting material as defined above, or another material or combination of materials that support hole-electron recombination. The emitting material is typically chosen from highly fluorescent dyes and phosphorescent compounds, e.g., transition metal complexes as described in WO 98/55561 A1, WO 00/18851 A1, WO 00/57676 A1, and WO 00/70655. Emitting materials are typically incorporated at 0.01 to 20 % by volume of the host material.

The host and emitting materials can be small nonpolymeric molecules or polymeric materials including polyfluorenes and polyvinylarylenes, e.g., poly(p-phenylenevinylene), PPV. In the case of polymers, small molecule emitting materials can be molecularly dispersed into a polymeric host, or the emitting materials can be added by copolymerizing a minor constituent into a host polymer.

An important relationship for choosing an emitting material is a comparison of the electron energy bandgap that is defined as the energy difference between the highest occupied molecular orbital and the lowest unoccupied molecular orbital of the molecule. For efficient energy transfer from the host to the emitting material, a necessary condition is that the bandgap of the dopant is smaller than that of the host material. For phosphorescent emitters (including materials that emit from a triplet excited state, i.e., so-called "triplet emitters") it is also important that the triplet energy level of the host be high enough to enable energy transfer from host to emitting material.

Host and emitting materials known to be of use include, but are not limited to, those disclosed in U.S. Patents 4,768,292, 5,141,671, 5,150,006, 5,151,629, 5,405,709, 5,484,922, 5,593,788, 5,645,948, 5,683,823, 5,755,999, 5,928,802, 5,935,720, 5,935,721, 6,020,078, 6,475,648, 6,534,199, 6,661,023, U.S. Patent Application Publications 2002/0127427 A1, 2003/0198829 A1, 2003/0203234 A1, 2003/0224202 A1, and 2004/0001969 A1.

Metal complexes of 8-hydroxyquinoline (oxine), otherwise known as chelated oxinoid compound, and similar derivatives constitute one class of useful host compounds capable of supporting electroluminescence. Illustrative of useful chelated oxinoid compounds are the following:
CO-1: Aluminum trisoxine [alias, tris(8-quinolinolato)aluminum(III)];
CO-2: Magnesium bisoxine [alias, bis(8-quinolinolato)magnesium(II)];
CO-3: Bis[benzo{f}-8-quinolinolato]zinc (II);
CO-4: Bis(2-methyl-8-quinolinolato)aluminum(III)-µ-oxo-bis(2-methyl-8-quinolinolato) aluminum(III);
CO-5: Indium trisoxine [alias, tris(8-quinolinolato)indium];
CO-6: Aluminum tris(5-methyloxine) [alias, tris(5-methyl-8-quinolinolato) aluminum(III)];
CO-7: Lithium oxine [alias, (8-quinolinolato)lithium(I)];
CO-8: Gallium oxine [alias, tris(8-quinolinolato)gallium(III)]; and
CO-9: Zirconium oxine [alias, tetra(8-quinolinolato)zirconium(IV)]

Another class of useful host materials includes derivatives of anthracene, such as those described in U.S. Patents 5,935,721, 5,972,247, 6,465,115, 6,534,199, 6,713,192, U.S. Patent Application Publications 2002/0048687 A1, 2003/0072966 A1, and WO 2004/018587. Some examples include derivatives of 9,10-dinaphthylanthracene and 9-naphthyl-10-phenylanthracene. Other useful classes of host materials include distyrylarylene derivatives as described in U.S. Patent 5,121,029, and benzazole derivatives, for example, 2, 2', 2"-(1,3,5-phenylene)tris[1-phenyl-1H-benzimidazole].

Suitable host materials for phosphorescent dopants should be selected so that a triplet exciton can be transferred efficiently from the host material to the phosphorescent material. For this transfer to occur, it is a highly desirable condition that the excited state energy of the phosphorescent material be lower than the difference in energy between the lowest triplet state and the ground state of the host. However, the bandgap of the host should not be chosen so large as to cause an unacceptable increase in the drive voltage of the OLEDs. Suitable host materials are described in WO 00/70655 A2, WO 01/39234 A2, WO 01/93642 A1, WO 02/074015 A2, WO 02/15645 A1, and U.S. Patent Application Publication 2002/0117662 A1. Suitable hosts include certain aryl amines, triazoles, indoles and carbazole compounds. Examples of desirable hosts are 4,4'-N,N'-dicarbazole-biphenyl (CBP), 2,2'-dimethyl-4,4'-N,N'-dicarbazole-biphenyl, *m*-(N,N'-dicarbazole)benzene, and poly(N-vinylcarbazole), including their derivatives.

Desirable host materials are capable of forming a continuous film. The light-emitting layer can contain more than one host material in order to improve the device's film morphology, electrical properties, light emission efficiency, and lifetime. Mixtures of electron-transporting and hole-transporting materials are known as useful hosts. In addition, mixtures of the above listed host materials with hole-transporting or electron-transporting materials can make suitable hosts.

Useful fluorescent dopants include, but are not limited to, derivatives of anthracene, tetracene, xanthene, perylene, rubrene, coumarin, rhodamine, and quinacridone, dicyanomethylenepyran compounds, thiopyran compounds, polymethine compounds, pyrylium and thiapyrylium compounds, fluorene derivatives, periflanthene derivatives, indenoperylene derivatives, bis(azinyl)amine boron compounds, bis(azinyl)methane boron compounds, derivatives of distryrylbenzene and distyrylbiphenyl, and carbostyryl compounds. Among derivatives of distyrylbenzene, particularly useful are those substituted with diarylamino groups, informally known as distyrylamines.

Examples of useful phosphorescent dopants that can be used in light-emitting layers of this invention include, but are not limited to, those described in WO 00/57676 A1, WO 00/70655, WO 01/41512 A1, WO 02/15645 A1, WO 01/93642 A1, WO 01/39234 A2, WO 02/071813 A1, WO 02/074015 A2, U.S. Patent Application Publications 2003/0017361 A1, 2002/0197511 A1, 2003/0072964 A1, 2003/0068528 A1, 2003/0059646 A1, 2003/0054198 A1, 2003/0124381 A1, 2002/0100906 A1, 2003/0068526 A1, 2003/0068535 A1, 2003/0141809A1, 2003/0040627 A1, 2002/0121638 A1, U.S. Patents 6,458,475, 6,573,651, 6,451,455, 6,413,656, 6,515,298, 6,451,415, 6,097,147, EP 1 239 526 A2, EP 1 238 981 A2, and EP 1 244 155 A2. Useful phosphorescent dopants include transition metal complexes, such as iridium and platinum complexes.

In some cases it is useful for one or more of the LELs within an EL unit to emit broadband light, for example white light. Multiple dopants can be added to one or more layers in order to produce a white-emitting OLED, for example, by combining blue- and yellow-emitting materials, cyan- and red-emitting materials, or red-, green-, and blue-emitting materials. White-emitting devices are described, for example, in EP 1 187 235, EP 1 182 244, U.S. Patents 5,683,823, 5,503,910, 5,405,709, 5,283,182, 6,627,333, 6,696,177, 6,720,092, U.S. Patent Application Publications 2002/0186214 A1, 2002/0025419 A1, and 2004/0009367 A1. In some of these systems, the host for one light-emitting layer is a hole-transporting material. For example, it is known in the art that emitting dopants can be added to the HTL **140**, thereby enabling HTL **140** to serve as a host. The thickness of each LEL can be in the range of from 5 nm to 80 nm, preferably, in the range of from 10 nm to 40 nm.

Preferred organic materials for use in forming the ETL **160** are metal chelated oxinoid compounds, including chelates of oxine itself, also commonly referred to as 8-quinolinol or 8-hydroxyquinoline. Such compounds help to inject and transport electrons, exhibit high levels of performance, and are readily deposited to form thin films. Exemplary oxinoid compounds have been listed above from CO-1 to CO-9 (the oxinoid compounds can be used as both the host material in LEL **150** and the electron-transporting material in ETL **160**).

Other electron-transporting materials include various butadiene derivatives as disclosed in U.S. Patent 4,356,429 and various heterocyclic optical brighteners as described in U.S. Patent 4,539,507. Benzazoles, oxadiazoles, triazoles, pyridinethiadiazoles, triazines, phenanthroline derivatives, and some silole derivatives are also useful electron-transporting materials.

The 1^{st} EIL **271** as shown in FIGS. 2-5 is an n-type doped layer composed of an electron-transporting material as a host material and an n-type dopant material (this EIL can also be called an n-type doped 1^{st} EIL 271). The reduction potential of the organic host materials in the 1^{st} EIL **271** is less than -1.0 V vs. SCE and one of the dopant materials is capable of reducing one of the organic host materials. The term " n-type doped layer" means that this layer has semiconducting properties after doping, and the electrical current through this layer is substantially carried by the electrons. The host material is capable of supporting electron injection and electron transport. The material for the n-type doped 1^{st} EIL **271** tris(8-hydroxyquinoline)-aluminum (Alq).

Both 1^{st} EIL **271** and ETL **160** in the OLEDs can use the same or different material.

The n-type dopant in the n-type doped 1^{st} EIL **271** is Li. The n-type doped concentration is preferably in the range of 0.01-20% by volume of this layer. The thickness of the n-type doped 1^{st} EIL **271** is typically less than 200 nm, and preferably in the range of 2 to 150 nm.

The 2^{nd} EIL **272** in the OLEDs as shown in FIGS. 2-5 is disposed in contact with the 1^{st} EIL **271**, and is composed of an organic material having a reduction potential greater than -1.0 V vs. SCE, which is hexaazatriphenylene hexacarbonitrile (HAT-CN)

The organic material HAT-CN has a reduction potential greater than -1.0 V vs. SCE and is a promising n-type semiconducting material with electron accepting property. The material can provide effective electron transport in OLEDs. Furthermore, by "electron accepting property" it is meant that the organic material has the capability or tendency to accept at least some electronic charge from other types of material that it is adjacent to. Having electron accepting property also means having a strong oxidizing property. Therefore, the 2^{nd} EIL **272** can also react with the first several monolayers of the cathode when the cathode layer is formed on top of the 2^{nd} EIL **272.** As a result, cathode **180** can have an improved contact with the 2^{nd} EIL **272** forming a stable interface between the 2^{nd} EIL **272** and the cathode **180**. The 2^{nd} EIL **272** can be as thin as 1 nm. However, it can also be as thick as 200 nm. Preferably, the thickness of 2^{nd} EIL **272** is in the range of from 1 to 150 nm.

The term "reduction potential", expressed in volts and abbreviated E^{red}, measures the affinity of a substance for an electron: the larger (more positive) the number, the greater the affinity. The reduction potential of a substance can be conveniently obtained by cyclic voltammetry (CV) and it is measured vs. SCE. The measurement of the reduction potential of a substance can be as following: An electrochemical analyzer (for instance, a CHI660 electrochemical analyzer, made by CH Instruments, Inc., Austin, TX) is employed to carry out the electrochemical measurements. Both CV and Osteryoung square-wave voltammetry (SWV) can be used to characterize the redox properties of the substance. A glassy carbon (GC) disk electrode (A=0.071 cm²) is used as working electrode. The GC electrode is polished with 0.05 µm alumina slurry, followed by sonication cleaning in deionized water twice and rinsed with acetone between the two water cleanings. The electrode is finally cleaned and activated by electrochemical treatment prior to use. A platinum wire can be used as the counter electrode and the SCE is used as a quasi-reference electrode to complete a standard 3-electrode electrochemical cell. A mixture of acetonitrile and toluene (1:1 MeCN/toluene) or methylene chloride (MeCl₂) can be used as organic solvent systems. All solvents used are ultra low water grade (<10 ppm water). The supporting electrolyte, tetrabutylammonium tetrafluoroborate (TBAF) is recrystallized twice in isopropanol and dried under vacuum for three days. Ferrocene (Fc) can be used as an internal standard (E^{red}_{Fc}=0.50 V vs. SCE in 1:1 MeCN/toluene, E^{red}_{Fc}=0.55 V vs. SCE in MeCl₂, 0.1 M TBAF, both values referring to the reduction of the ferrocenium radical anion). The testing solution is purged with high purity nitrogen gas for approximately 15 minutes to remove oxygen and a nitrogen blanket is kept on the top of the solution during the course of the experiments. All measurements are performed at an ambient temperature of 25 ± 1°C. If the compound of interest has insufficient solubility, other solvents can be selected and used by those skilled in the art. Alternatively, if a suitable solvent system cannot be identified, the electron accepting material can be deposited onto the electrode and the reduction potential of the modified electrode can be measured.

The organic material used in the 2^{nd} EIL **272** is the chemical compound of Formula IIIa, (hexaazatriphenylene hexacarbonitrile)

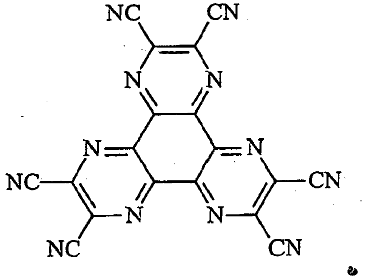

The 2^{nd} EIL 272 can also be doped with an n-type dopant material having a work function less than 4.0 eV into the organic host material, which is lithium.

Additional layers such as exciton, electron and hole-blocking layers as taught in the art can be employed in devices of this invention. Hole-blocking layers are commonly used to improve efficiency of phosphorescent emitter devices, for example, as in U.S. Patent Application Publications 2002/0015859 A1, 2003/0068528 A1, 2003/0175553 A1, WO 00/70655 A2, and WO 01/93642 A1

Each of the layers in the organic EL units in the OLEDs can be formed from small molecule (or nonpolymeric) materials (including fluorescent materials and phosphorescent materials), polymeric LED materials, or inorganic materials, or combinations thereof.

When light emission is viewed solely through the anode, the cathode **180** can include nearly any conductive material. Desirable materials have effective film forming properties to ensure effective contact with the underlying organic layer, promote electron injection at low voltage, and have effective stability. Commonly used cathodes include a Mg:Ag alloy as described in U.S. Patent 4,885,221, a LiF/Al bilayer as described in U.S. Patent 5,677,572, Al, Ag, Au, Cu, or a combination thereof. Other useful cathodes include, but are not limited to, those disclosed in U.S. Patents 5,059,861, 5,059,862, and 6,140,763. Since the 2^{nd} EIL **272** includes the organic material having a reduction potential greater than -1.0 V vs. SCE, the deposited cathode can form a stable interface with the 2^{nd} EIL **272** resulting in less interface degradation during operation as well as less dark spots due to less reaction with water or oxygen during storage. It is preferable that the barrier to injection of electrons from the cathode material into the 2^{nd} EIL be no greater than 0.3 eV.

When light emission is viewed through the cathode, the cathode should be transparent or nearly transparent. For such applications, metals should be thin or one should use transparent conductive oxides, or include these materials. Optically transparent cathodes have been described in more detail in U.S. Patents 4,885,211, 5,247,190, 5,703,436, 5,608,287, 5,837,391, 5,677,572, 5,776,622, 5,776,623, 5,714,838, 5,969,474, 5,739,545, 5,981,306, 6,137,223, 6,140,763, 6,172,459, 6,278,236, 6,284,393, and EP 1 076 368. Cathode materials are typically deposited by thermal evaporation, electron beam evaporation, ion sputtering, or chemical vapor deposition. When needed, patterning can be achieved through many well known methods including, but not limited to, through-mask deposition, integral shadow masking, for example as described in U.S. Patent 5,276,380 and EP 0 732 868, laser ablation, and selective chemical vapor deposition.

This invention can be used in a so-called tandem device architecture, for example, as taught in U.S. Patents 6,337,492, 6,717,358, and U.S. Patent Application Publication 2003/0170491 A1. Such tandem devices have multiple electroluminescent units provided between an anode and a cathode, typically with connector layer between units to promote charge production and injection into the electroluminescent units.

The organic materials mentioned above are suitably deposited through a vapor-phase method such as sublimation, but can be deposited from a fluid, for example, from a solvent with an optional binder to improve film formation. If the material is a polymer, solvent deposition is useful but other methods can be used, such as sputtering or thermal transfer from a donor sheet. The material to be deposited by sublimation can be vaporized from a sublimation "boat" often including a tantalum material, e.g., as described in U.S. Patent 6,237,529, or can be first coated onto a donor sheet and then sublimed in closer proximity to the substrate. Layers with a mixture of materials can use separate sublimation boats or the materials can be premixed and coated from a single boat or donor sheet. Patterned deposition can be achieved using shadow masks, integral shadow masks (U.S. Patent 5,294,870), spatially defined thermal dye transfer from a donor sheet (U.S. Patents 5,688,551, 5,851,709 and 6,066,357), and inkjet method (U.S. Patent 6,066,357).

Most OLED devices are sensitive to moisture or oxygen, or both, so they are commonly sealed in an inert atmosphere such as nitrogen or argon. In sealing an OLED device in an inert environment, a protective cover can be attached using an organic adhesive, a metal solder, or a low melting temperature glass. Commonly, a getter or desiccant is also provided within the sealed space. Useful getters and desiccants include, alkali and alkaline metals, alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in U.S. Patent 6,226,890. In addition, barrier layers such as SiOx, Teflon, and alternating inorganic/polymeric layers are known in the art for encapsulation.

OLED devices of this invention can employ various well known optical effects in order to enhance its properties if desired. This includes optimizing layer thicknesses to yield maximum light transmission, providing dielectric mirror structures, replacing reflective electrodes with light-absorbing electrodes, providing anti glare or antireflection coatings over the display, providing a polarizing medium over the display, or providing colored, neutral density, or color conversion filters in functional relationship with the light emitting areas of the display. Filters, polarizers, and antiglare or antireflection coatings can also be provided over a cover or as part of a cover.

The OLED device can have a microcavity structure. In one useful example, one of the metallic electrodes is essentially opaque and reflective; the other one is reflective and semitransparent. The reflective electrode is preferably selected from Au, Ag, Mg, Ca, or alloys thereof. Because of the presence of the two reflecting metal electrodes, the device has a microcavity structure. The strong optical interference in this structure results in a resonance condition. Emission near the resonance wavelength is enhanced and emission away from the resonance wavelength is depressed. The optical path length can be tuned by selecting the thickness of the organic layers or by placing a transparent optical spacer between the electrodes. For example, an OLED device of this invention can have ITO spacer layer placed between a reflective anode and the organic EL media, with a semitransparent cathode over the organic EL media.

The aforementioned OLEDs prepared in accordance with the present invention are useful in applications. OLED displays or the other electronic devices can include a plurality of the OLEDs as described above.

### EXAMPLES

The following examples are presented for a further understanding of the present invention. In the following examples, the reduction potentials of the materials were measured using an electrochemical analyzer (CHI660 electrochemical analyzer, made by CH Instruments, Inc., Austin, TX) with the method as discussed before. During the fabrication of OLEDs, the thickness of the organic layers and the doping concentrations were controlled and measured in situ using calibrated thickness monitors (INFICON IC/5 Deposition Controller, made by Inficon Inc., Syracuse, NY). The EL characteristics of all the fabricated devices were evaluated using a constant current source (KEITHLEY 2400 SourceMeter, made by Keithley Instruments, Inc., Cleveland, Ohio) and a photometer (PHOTO RESEARCH SpectraScan PR 650, made by Photo Research, Inc., Chatsworth, CA) at room temperature. Operational stabilities of the devices were tested at room temperature by driving a direct current of 80 mA/cm² through the devices.

### Example 1 (Comparative)

The preparation of a conventional OLED is as follows: A ~1.1 mm thick glass substrate coated with a transparent ITO conductive layer was cleaned and dried using a commercial glass scrubber tool. The thickness of ITO is about 42 nm and the sheet resistance of the ITO is about 68 Ω/square. The ITO surface was subsequently treated with oxidative plasma to condition the surface as an anode. A layer of CFx, 1 nm thick, was deposited on the clean ITO surface as the anode buffer layer by decomposing CHF₃ gas in an RF plasma treatment chamber. The substrate was then transferred into a vacuum deposition chamber for deposition of all other layers on top of the substrate. The following layers were deposited in the following sequence by evaporation from a heated boat under a vacuum of approximately 10⁻⁶ Torr:
1. EL Unit:
   a) an HIL, 10 nm thick, composed of hexaazatriphenylene hexacarbonitrile (HAT-CN);
   b) an HTL, 65 nm thick, composed of 4,4'- bis[N-(1-naphthyl)-N-phenylamino]biphenyl (NPB);
   c) a LEL, 30 nm thick, composed of tris(8-hydroxyquinoline)-aluminum (Alq) doped with 1.0 vol% 10-(2-benzothiazolyl)-1,1,7,7-tetramethyl-2,3,6,7-tetrahydro-1H,5H,11H(1)benzopyrano(6,7,8-ij)quinolizin-11-one (C545T); and
   d) an EIL, 30 nm thick, composed of Alq doped with about 1.2 vol% lithium.
2. Cathode: approximately 210 nm thick, composed of Mg:Ag (formed by coevaporation of about 95 vol% Mg and 5 vol% Ag).

After the deposition of these layers, the device was transferred from the deposition chamber into a dry box (made by VAC Vacuum Atmosphere Company, Hawthorne, CA) for encapsulation. The OLED has an emission area of 10 mm². The reduction potentials of HAT-CN and Alq were measured as about -0.01 V and -1.77 V vs. SCE in the 1:1 MeCN/toluene organic solvent system, respectively.

This conventional OLED requires a drive voltage of about 5.0 V to pass 20 mA/cm². Under this test condition, the device has a luminance of 1905 cd/m², and a luminous efficiency of about 9.5 cd/A. Its emission peak is at 521 nm.

### Example 2 (Comparative)

Another OLED was constructed as the same as that in Example 1, except that the 30-nm-thick Li-doped Alq layer (the EIL formed as layer d) in Example 1 was replaced by a 30-nm-thick HAT-CN layer as an EIL Example 2.

This OLED requires a drive voltage of about 5.4 V to pass 20 mA/cm². However, there is no light emission from this device. This observation indicates that the HAT-CN layer having a reduction potential greater than -1.0 V vs. SCE cannot be effectively used as an EIL in this device configuration.

### Example 3 (Comparative)

Another OLED was constructed as the same as that in Example 1, except that the 30-nm-thick Li-doped Alq layer (the EIL, layer d) in Example 1 was replaced by a 30-nm-thick HAT-CN layer doped with about 1.2 vol% lithium as an EIL in Example 3.

This OLED requires a drive voltage of about 5.2 V to pass 20 mA/cm². However, there is no light emission from this device. This observation indicates that the Li-doped HAT-CN layer also cannot be effectively used as an EIL in this device configuration.

### Example 4 (Comparative)

Another OLED was constructed in the same manner as that in Example 1. However, the layer structure of the EL unit is as follows:
a) an HTL, 75 nm thick, composed of NPB;
b) a LEL, 30 nm thick, composed of Alq doped with 1.0 vol% C545T; and
c) an ETL, 30 nm thick, composed of Alq.

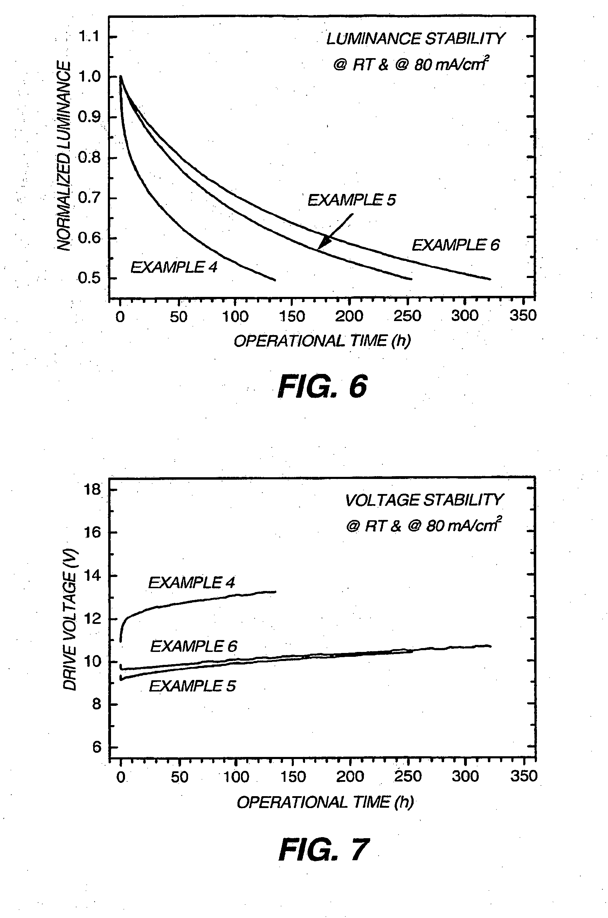

This conventional OLED requires a drive voltage of about 6.6 V to pass 20 mA/cm². Under this test condition, the device has a luminance of 1977 cd/m², and a luminous efficiency of about 9.9 cd/A. Its emission peak is at 522 nm. The operational lifetime was measured as T₅₀(RT@80 mA/cm²) (i.e. the time at which the luminance has fallen to 50% of its initial value after being operated at room temperature and at 80 mA/cm²). Its T₅₀(RT@80 mA/cm²) is about 130 hours. The average rate of the voltage rise during the lifetime testing is about 17 mV/hr. Its normalized luminance vs. operational time and its drive voltage vs. operational time, tested at room temperature and at 80 mA/cm², are shown in FIGS. 6 and 7, respectively.

### Example 5 (Comparative)

Another OLED was constructed as the same as that in Example 4, except that the layer c in Example 4 was replaced by:
c) an EIL, 30 nm thick, composed of Alq doped with about 1.2 vol% lithium.

This OLED, requires a drive voltage of about 4.6 V to pass 20 mA/cm². Under this test condition, the device has a luminance of 2008 cd/m², and a luminous efficiency of about 10.0 cd/A. Its emission peak is at 522 nm. The operational lifetime, measured as T₅₀(RT@80 mA/cm²), is about 246 hours. The average rate of the voltage rise during the lifetime testing is about 5.0 mV/hr. Its normalized luminance vs. operational time and its drive voltage vs. operational time, tested at room temperature and at 80 mA/cm², are shown in FIGS. 6 and 7, respectively.

### Example 6 (Inventive)

An OLED in accordance with the present invention was constructed as the same as that in Example 4, except that the layer c in Example 4 was replaced by:
c) the 1^{st} EIL, 29 nm thick, composed of Alq doped with about 1.2 vol% lithium; and
d) the 2^{nd} EIL, 1 nm thick, composed of HAT-CN.

This OLED, having the 2^{nd} EIL in direct contact with the 1^{st} EIL, requires a drive voltage of about 5.0 V to pass 20 mA/cm². Under this test condition, the device has a luminance of 1891 cd/m², and a luminous efficiency of about 9.5 cd/A. Its emission peak is at 521 nm. The operational lifetime, measured as T₅₀(RT@80 mA/cm²), is about 312 hours. The average rate of the voltage rise during the lifetime testing is about 3.5 mV/hr. Its normalized luminance vs. operational time and its drive voltage vs. operational time, tested at room temperature and at 80 mA/cm², are shown in FIGS. 6 and 7, respectively.

FIGS. 6 and 7 demonstrate that the OLED constructed in accordance with the present invention can have improved lifetime and improved voltage rise. The following examples will show how one can further reduce the drive voltage.

### Example 7 (Inventive)

Another OLED in accordance with the present invention was constructed in the same general manner as that in Example 1. But, the layer structure of the EL unit is as follows:
a) an HIL, 10nm thick, composed of HAT-CN;
b) an HTL, 65 nm thick, composed of NPB;
c) a LEL, 30 nm thick, composed of Alq doped with 1.0 vol% C545T;
d) the 1^{st} EIL, 20 nm thick, composed of Alq doped with about 1.2 vol% lithium; and
e) the 2^{nd} EIL, 10 nm thick, composed of HAT-CN.

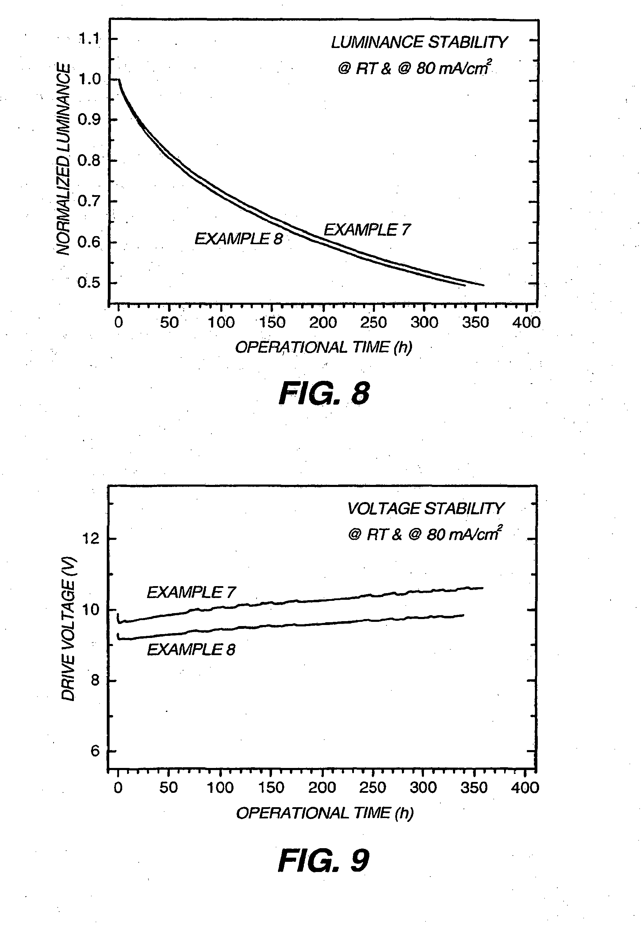

This OLED requires a drive voltage of about 5.1 V to pass 20 mA/cm². Under this test condition, the device has a luminance of 1823 cd/m², and a luminous efficiency of about 9.1-cd/A. Its emission peak is at 521 nm. The operational lifetime, measured as T₅₀(RT@80 mA/cm²), is about 350 hours. The average rate of the voltage rise during the lifetime testing is about 2.9 mV/hr. Its normalized luminance vs. operational time and its drive voltage vs. operational time, tested at room temperature and at 80 mA/cm², are shown in FIGS. 8 and 9, respectively.

### Example 8 (Inventive)

Another OLED was constructed in accordance with the present invention. This OLED is the same as that in Example 7, except that layers d and e were changed as follows:
d) the 1^{st} EIL, 5 nm thick, composed of Alq doped with about 1.2 vol% lithium; and
e) the 2^{nd} EIL, 25 nm thick, composed of HAT-CN doped with about 1.2 vol% lithium.

This OLED requires a drive voltage of about 4.6 V to pass 20 mA/cm². Under this test condition, the device has a luminance of 1898 cd/m², and a luminous efficiency of about 9.5 cd/A. Its emission peak is at 521 nm. The operational lifetime, measured as T₅₀(RT@80 mA/cm²), is about 330 hours. The average rate of the voltage rise during the lifetime testing is about 2.1 mV/hr. Its normalized luminance vs. operational time and its drive voltage vs. operational time, tested at room temperature and at 80 mA/cm², are shown in FIGS. 8 and 9, respectively.

It is evident from FIGS. 8 and 9 that the OLEDs having a Li-doped HAT-CN layer as the 2^{nd} EIL can further reduce both the drive voltage and the voltage rise during operation.

### PARTS LIST

- 100: OLED
- 110: substrate
- 120: anode
- 130: hole-injecting layer (HIL)
- 140: hole-transporting layer (HTL)
- 150: light-emitting layer (LEL)
- 160: electron-transporting layer (ETL)
- 170: electron-injecting layer (EIL)
- 180: cathode
- 191: electrical conductors
- 192: voltage/current source
- 200: OLED
- 271: 1^{st} electron-injecting layer (1^{st} EIL)
- 272: 2^{nd} electron-injecting layer (2^{nd} EIL)
- 300: OLED
- 400: OLED
- 500: OLED

## Claims

1. An organic light-emitting device (OLED) (200) comprising in the following order, an anode (120), a light-emitting layer disposed over the anode (150), a first electron-injecting layer (271), a second electron-injecting layer (272) and a cathode; **characterized by**:
the first electron-injecting layer (271) is composed of an organic host material having a reduction potential less than -1.0 V vs. a Saturated Calomel Electrode which is tris(8-hydroxyquinoline)-aluminum (Alq) and a dopant material capable of reducing the organic host material which is lithium;
the second electron-injecting layer (272) is disposed in contact with the first electron-injecting layer (271) and includes at least one organic material having a reduction potential greater than -1.0 V vs. a Saturated Calomel Electrode;
the cathode (180) is disposed in direct contact with the second electron-injecting layer (272); and **characterized in that** the second electron-injecting layer (272) comprises the chemical compound having the structure of 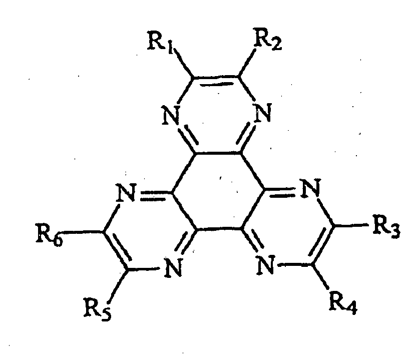 wherein R₁-R₆ represent (-CN) and, optionally, an n-type dopant which is lithium.

2. The OLED (200) of claim 1 wherein the first electron-injecting layer (271) has a thickness in a range of from 2 to 150 nm.

3. The OLED (200) of claim 1 wherein the second electron-injecting layer (272) has a thickness in a range of from 1 to 150 nm.

4. The OLED (200) of claim 1 wherein the concentration of the dopant material in the second electron-injecting layer (272) is in the range of from 0.01% to 20% by volume.

## Patentansprüche

1. Organische lichtemittierende Vorrichtung (OLED) (200), umfassend in der folgenden Reihenfolge eine Anode (120), eine lichtemittierende Schicht, aufgebracht auf der Anode (150), eine erste elektroneninjizierende Schicht (271), eine zweite elektroneninjizierende Schicht (272), und eine Kathode; **dadurch gekennzeichnet, dass**:
die erste elektroneninjizierende Schicht (271) besteht aus einem organischen Gastmaterial mit einem Reduktionspotential unterhalb von -1,0 V gegenüber einer gesättigten Calomelelektrode, welches Tris(8-hydroxychinolin)aluminium (Alq) darstellt, und einem zur Reduzierung des organischen Gastmaterials fähigen Dotierungsmaterial, welches Lithium darstellt;
die zweite elektroneninjizierende Schicht (272) in Kontakt mit der ersten elektroneninjizierenden Schicht (271) aufgebracht ist und mindestens ein organisches Material mit einem Reduktionspotential oberhalb von -1,0 V gegenüber einer gesättigten Calomelelektrode enthält;
die Kathode (180) in direktem Kontakt mit der zweiten elektroneninjizierenden Schicht (272) aufgebracht ist; und **dadurch gekennzeichnet, dass** die zweite elektroneninjizierende Schicht (272) die chemische Verbindung mit der Struktur 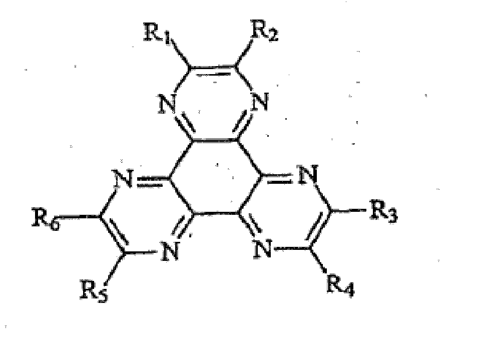 worin R₁- R₆ (-CN) repräsentieren, und wahlweise ein n-Typ Dotierungsmittel, welches Lithium darstellt, umfasst.

2. OLED (200) nach Anspruch 1, worin die erste elektroneninjizierende Schicht (271) eine Dicke in einem Bereich von 2 bis 150 nm aufweist.

3. OLED (200) nach Anspruch 1, worin die zweite elektroneninjizierende Schicht (272) eine Dicke in einem Bereich von 1 bis 150 nm aufweist.

4. OLED (200) nach Anspruch 1, worin die Konzentration des Dotierungsmaterials in der zweiten elektroneninjizierenden Schicht (272) in dem Bereich von 0,01 bis 20 Volumenprozent liegt.

## Revendications

1. Une diode électroluminescente organique (OLED) (200) comprenant dans l'ordre suivant, une anode (120), une couche émettrice de lumière placée en dessus de l'anode (150), une première couche d'injection d'électrons (271), une seconde couche d'injection d'électrons (272) et une cathode ; **caractérisé en ce que** :
la première couche d'injection d'électrons (271) est composée d'un matériau hôte organique ayant un potentiel de réduction inférieur à -1,0 V par rapport à une électrode au calomel saturé qui correspond au tris(8-hydroxyquinoline)-aluminium (Alq) et un matériau de dopage capable de réduire le matériau hôte organique qui correspond au lithium ;
la seconde couche d'injection d'électrons (272) est placée en contact avec la première couche d'injection d'électrons (271) et comprend au moins un matériau organique ayant un potentiel de réduction supérieur à -1,0 V par rapport à une électrode de calomel saturé ;
la cathode (180) est placée en contact direct avec la seconde couche d'injection d'électrons (272) ; et **caractérisé en ce que** la seconde couche d'injection d'électrons (272) comprend le composé chimique ayant la structure de 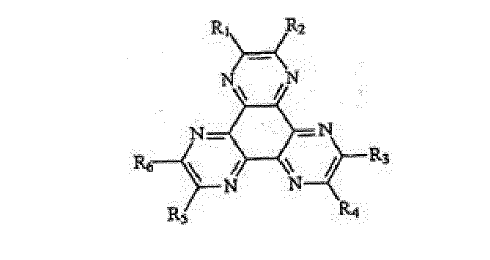
dans laquelle R₁-R₆ représentent (-CN) et, optionnellement, un dopant de type n qui correspond au lithium.

2. L'OLED (200) selon la revendication 1, dans lequel la première couche d'injection d'électrons (271) a une épaisseur dans une plage de 2 à 150 nm.

3. L'OLED (200) selon la revendication 1, dans lequel la seconde couche d'injection d'électrons (272) a une épaisseur dans une plage de 1 à 150 nm.

4. L'OLED (200) selon la revendication 1, dans lequel la concentration du matériau de dopage dans la seconde couche d'injection d'électrons (272) est dans la plage de 0,01 % à 20% par volume.
